# EUROPEAN PATENT APPLICATION

(11) **EP 4 534 568 A1**
(43) Date of publication of application: **09.04.2025**
(21) Application number: 23811798.0
(22) Date of filing: 23.05.2023
(51) Int. Cl.: C08F 8/12, C08F 212/04, C08F 220/12, G03F 7/039

(54) **POLYMER AND RESIN COMPOSITION FOR RESIST**

(30) Priority: 24.05.2022 JP 2022084421
(71) Applicant: Maruzen Petrochemical Co., Ltd., Tokyo 104-8502 (JP)
(72) Inventor: MASUKAWA, Tomohiro, Ichihara-shi, Chiba 290-8503 (JP); AIHARA, Hiromichi, Ichihara-shi, Chiba 290-8503 (JP); KASAHARA, Taku, Ichihara-shi, Chiba 290-8503 (JP); SAGA, Yuta, Ichihara-shi, Chiba 290-8503 (JP)
(74) Representative: Regimbeau
(86) International application number: PCT/JP2023/019061
(87) International publication number: WO 2023/228926

(57) **Abstract**

[Problem] To provide a polymer for resists, which is excellent in storage stability and is high in sensitivity and high in resolution performance.

[Solution] The polymer according to the present invention contains a structural unit having a phenolic hydroxyl group and a structural unit having a structure in which carboxylic acid is protected with an acetal group.

## Description

### BACKGROUND OF THE INVENTION

### Field of the Invention

The present invention relates to a polymer useful for photoresist materials, and a resin composition for resists including the polymer.

### Background Art

Microfabrication by lithography with photoresist compositions has been conventionally performed in processes for manufacturing semiconductor devices such as IC and LSI. In recent years, as integrated circuits have been highly integrated, formation of ultrafine patterns in the sub-micron region or quarter-micron region has been increasingly demanded, and KrF excimer laser and ArF excimer laser shorter in wavelength have been increasingly used rather than g-beam and i-beam in exposure light sources for volume production of semiconductors. Furthermore, development of lithography techniques with electron beam, X-ray, or extreme ultraviolet light (EUV) is currently advanced.

Such lithography with electron beam, X-ray, or EUV is positioned as the next-generation or next-next generation of patterning techniques, and resist compositions high in sensitivity and high in resolution performance are desired. While an increase in sensitivity of resists is a very important issue in particular for a decrease in wafer processing time, sensitivity and resolution performance are in a trade-off relationship and there is a strong demand for development of resist compositions simultaneously satisfying these properties.

In order to solve these problems, Patent Literature 1 and 2 propose a polymer containing a structural unit having a phenolic hydroxyl group and a structural unit having a structure in which carboxylic acid is protected with an acetal group. However, when a monomer having a phenolic hydroxyl group not protected and a monomer having a structure in which carboxylic acid is protected with an acetal group, as disclosed in the Patent Literatures, are directly polymerized, some acetal groups in the resulting polymer may be desorbed or an acetal moiety desorbed may be added to the phenolic hydroxyl group.

As a method for suppressing such desorption of an acetal group in a polymer, Patent Literature 3 discloses a method including polymerizing p-acetoxystyrene and a monomer having a structure in which carboxylic acid is protected with an acetal group, and then allowing the resulting polymer to react at a temperature ranging from 0 to 50°C in an organic solvent in the presence of a base whose conjugate acid has a pKa of 12 or more, thereby deprotecting the acetyl group and thus producing a polymer containing a structural unit having a phenolic hydroxyl group and a structural unit having a structure in which carboxylic acid is protected with an acetal group.

### Citation List

[Patent Literature 1] JP 2014-41326 A
[Patent Literature 2] JP 2014-41328 A
[Patent Literature 3] WO2021/029310

### SUMMARY OF THE INVENTION

### Technical Problem

There is currently a demand for a polymer for resists, which is more excellent in storage stability, and higher in sensitivity and higher in resolution performance than a polymer obtained by the method described in Patent Literature 3.

The present invention particularly provides a polymer for resists, which is excellent in storage stability and is high in sensitivity and high in resolution performance, and a resin composition for resists, including the polymer.

### Solution to Problem

The present inventors have made intensive studies in order to solve the above problems, and as a result, have found that desorption and transfer of an acetal group can be suppressed by introduction of an acyl group to an acetal protective group of carboxylic acid in a polymer, leading to completion of the present invention.

Specifically, the present invention provides the following.
[1] A polymer containing
   a structural unit I represented by the following general formula (i): 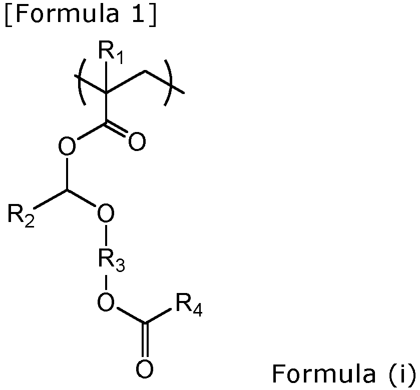 in the formula (i), R₁ represents a hydrogen atom or an alkyl group having 1 to 10 carbon atoms, R₂ represents an alkyl group having 1 to 10 carbon atoms, R₃ represents an alkylene group having 1 to 5 carbon atoms, and R₄ represents a hydrocarbon group having 1 to 20 carbon atoms, and
   a structural unit II represented by the following general formula (ii): 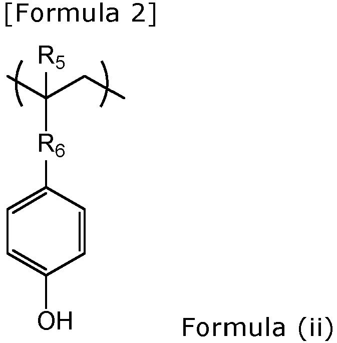 in the formula (ii), R₅ represents a hydrogen atom or an alkyl group having 1 to 10 carbon atoms, and R₆ represents a single bond or -C(=O)-O-.
[2] The polymer according to [1], wherein R₄ in the formula (i) is a hydrocarbon group containing an alicyclic group or an aryl group and having 5 to 20 carbon atoms.
[3] A polymer containing
   a structural unit I-1 represented by the following general formula (i-1): 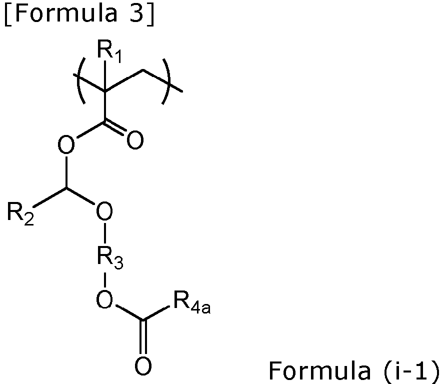 in the formula (i-1), R₁ represents a hydrogen atom or an alkyl group having 1 to 10 carbon atoms, R₂ represents an alkyl group having 1 to 10 carbon atoms, R₃ represents an alkylene group having 1 to 5 carbon atoms, and R₄ₐ represents a hydrocarbon group containing an alicyclic group or an aryl group and having 5 to 20 carbon atoms.
[4] A resin composition for resists, the resin composition including the polymer according to any one of [1] to [3].

### Advantageous Effect of Invention

The present invention can provide a polymer containing a structural unit having a structure in which carboxylic acid is protected with an acetal group, in which a structural unit due to desorption and transfer of an acetal group is extremely less generated and storage stability is also extremely favorable. The present invention can exert the above effects even if the polymer contains a structural unit having a phenolic hydroxyl group. The polymer is high in sensitivity and high in resolution, and is useful as a polymer for chemical amplification type resists.

### DESCRIPTION OF EMBODIMENTS

### [Polymer]

### [Structural unit I]

The polymer of the present invention contains at least a structural unit I represented by the general formula (i). When the polymer is used in a chemical amplification type resist, an acetal protective group of the structural unit I is desorbed by the action of acid and the solubility of the polymer in a developer is changed.

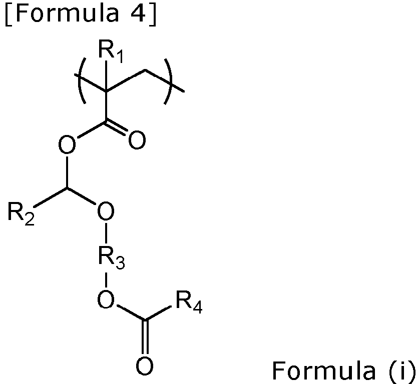

In the formula (i), R₁ represents a hydrogen atom or an alkyl group having 1 to 10 carbon atoms, preferably a hydrogen atom or a methyl group.

R₂ represents an alkyl group having 1 to 10 carbon atoms, preferably an alkyl group having 1 to 4 carbon atoms, further preferably a methyl group.

R₃ represents an alkylene group having 1 to 5 carbon atoms, preferably an alkylene group having 1 to 4 carbon atoms, further preferably an ethylene group.

R₄ represents a hydrocarbon group having 1 to 20 carbon atoms. The hydrocarbon group may be an alkyl group, an alicyclic group, an aryl group, or a group in which such groups are bound. Preferred is a hydrocarbon group containing an alicyclic group or an aryl group and having 5 to 20 carbon atoms.

The structural unit I is more preferably represented by the formula (i-1).

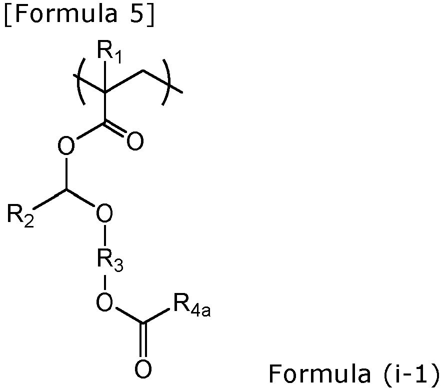

In the formula (i-1), R₁ represents a hydrogen atom or an alkyl group having 1 to 10 carbon atoms, preferably a hydrogen atom or a methyl group.

R₂ represents an alkyl group having 1 to 10 carbon atoms, preferably an alkyl group having 1 to 4 carbon atoms, further preferably a methyl group.

R₃ represents an alkylene group having 1 to 5 carbon atoms, preferably an alkylene group having 1 to 4 carbon atoms, further preferably an ethylene group.

R₄ₐ represents a hydrocarbon group containing an alicyclic group or an aryl group and having 5 to 20 carbon atoms. The alicyclic group preferably has 5 to 15 carbon atoms, more preferably 5 to 12 carbon atoms, and is specifically, for example, a monocyclic group such as a cyclopentyl group, a cyclohexyl group or a cycloocctyl group, or a group obtained by removing one hydrogen atom from a polycyclic aliphatic compound such as norbornane, bicyclo[4.3.0]nonane, decalin, or adamantane. The aryl group preferably has 6 to 15 carbon atoms, and specific examples thereof include a phenyl group, a tolyl group, a xylyl group, a naphthyl group, an anthracenyl group, and a biphenylyl group.

The proportion of the structural unit I contained in the polymer is preferably 1% by mol or more and 99% by mol or less, more preferably 10% by mol or more and 90% by mol or less, further preferably 30% by mol or more and less than 70% by mol based on 100% by mol in total of all the structural units.

### [Structural unit II]

The polymer of the present invention preferably further contains a structural unit II having a phenolic hydroxyl group, represented by the general formula (ii).

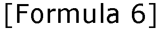

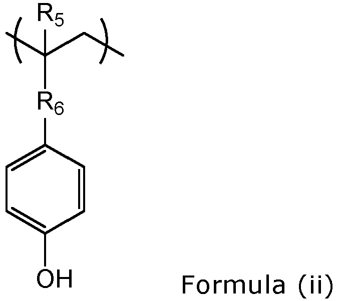

In the formula (ii), R₅ represents a hydrogen atom or an alkyl group having 1 to 10 carbon atoms, preferably a hydrogen atom or a methyl group.

R₆ represents a single bond or -C(=O)-O-. Herein, an oxygen atom is bound to a benzene ring.

The proportion of the structural unit II contained in the polymer is preferably 1% by mol or more and 99% by mol or less, more preferably 10% by mol or more and 90% by mol or less, further preferably more than 30% by mol and 70% by mol or less based on 100% by mol in total of all the structural units.

In general, a polymer having a structural unit in which carboxylic acid is protected with acetal, in particular, such a polymer also containing a structural unit having an acidic group such as a phenolic hydroxyl group, easily causes desorption of acetal. If desorption of acetal and subsequent transfer of acetal generate by-products such as a carboxylic acid structural unit and a structural unit having a structure in which acetal is added to a phenolic hydroxyl group, in the polymer, there occur undesirable cases, for example, not only resist performance such as a development rate may be affected, but also desorption of acetal further progresses due to the influence of carboxylic acid as a by-product and storage stability is rapidly impaired.

It has been found in the present invention that introduction of an acyl structure into an acetal group protecting carboxylic acid in a polymer leads to extremely favorable suppression of desorption of acetal even if a structural unit having a phenolic hydroxyl group is present in the same polymer. In particular, a case where the acyl structure contains an alicyclic group or an aryl group largely exerts such an effect and is preferred.

The polymer of the present invention may also contain any other structural unit, and such other structural unit can be introduced with variously known monomers used in production of a polymer for resists in order to adjust etching resistance of the polymer, substrate adhesiveness, solubility in a developer, and the like in photolithography.

The weight average molecular weight (Mw) and the degree of dispersion (Mw/Mn) of the polymer of the present invention can be appropriately set depending on the intended use and are not particularly limited. For example, the weight average molecular weight (Mw) is preferably 1,000 to 100,000, more preferably 2,000 to 50,000, further preferably 3,000 to 30,000, still more preferably 5,000 to 15,000 from the viewpoint of exhibition of polymer properties. The degree of dispersion (Mw/Mn) is preferably 1.1 or more and 2.0 or less, more preferably 1.2 or more and 1.80 or less, further preferably 1.3 or more and 1.7 or less from the viewpoint of homogenization of properties of the polymer.

In the present invention, the weight average molecular weight (Mw) and the molecular weight distribution (Mw/Mn) of the polymer are values measured by GPC (gel permeation chromatography), and can be measured under measurement conditions described below.

### [Method for producing polymer]

The polymer of the present invention can be produced by directly polymerizing at least a monomer corresponding to a structural unit represented by formula (i) and a monomer corresponding to a structural unit represented by formula (ii), or polymerizing at least a monomer corresponding to a structural unit represented by formula (i) and a monomer corresponding to a structure in which a phenolic hydroxyl group in formula (ii) is protected with a protective group, and then deprotecting the protective group of the phenolic hydroxyl group by a base.

### (Polymerization step)

A polymerization step in the production method in the present invention is not particularly limited, and any conventionally known polymerization method such as radical polymerization, cation polymerization, and living anion polymerization can be applied.

In the case of a method with radical polymerization, the method is performed by heating and stirring a raw material monomer, a radical polymerization initiator, and, if necessary, a chain transfer agent and/or the like which are dissolved in a solvent, preferably in an inert gas atmosphere such as nitrogen. For example, the method can be performed by, for example, a so-called batch polymerization method involving dissolving all raw materials such as a monomer, a polymerization initiator, and a chain transfer agent in a solvent and heating the solution to a polymerization temperature, a method involving dissolving a monomer in a solvent and heating the solution to a polymerization temperature, and then adding a polymerization initiator and the like, or a so-called dropping polymerization method involving dropping a solution obtained by dissolution of a monomer, a polymerization initiator, and the like in a solvent, into a solvent heated to a polymerization temperature. In particular, such a dropping polymerization method is preferred because the reproducibility per production lot is high, and a so-called independent dropping method is particularly preferred which involves separately dropping a monomer and a polymerization initiator serving as a radical generation source. Such monomer, polymerization initiator, chain transfer agent, and the like can also be each partially fed in a polymerization system in advance. In such a dropping method, the composition of a monomer solution to be fed, and the speeds of feeding of the monomer solution and the polymerization initiator can be changed to adjust the monomer concentration and the radical concentration in the polymerization system and control the degree of dispersion and the composition distribution of a copolymer to be produced.

The radical polymerization initiator here used can be conventionally known one, for example, an azo-based polymerization initiator or a peroxide-based polymerization initiator. Specific examples of the azo-based polymerization initiator can include 2,2'-azobisisobutyronitrile, 2,2'-azobis(2-methylbutyronitrile), dimethyl2,2'-azobis(2-methylpropionate), 1,1'-azobis(cyclohexane-1-carbonitrile), and 4,4'-azobis(4-cyanovaleric acid). A polymerization initiator of an azo-based compound is preferred because of being excellent in safety of handling. Specific examples of the peroxide-based polymerization initiator can include decanoyl peroxide, lauroyl peroxide, benzoyl peroxide, bis(3,5,5-trimethylhexanoyl)peroxide, succinic acid peroxide, tert-butyl peroxy-2-ethylhexanoate, tert-butyl peroxypivalate, and 1,1,3,3-tetramethylbutyl peroxy-2-ethylhexanoate. These polymerization initiators can be used singly, or mixed and then used. The amount of the polymerization initiator used can be selected depending on the intended molecular weight, the types of the monomer, the polymerization initiator, the chain transfer agent, the solvent, and the like, the structural unit composition, the polymerization temperature, the dropping rate, and the like.

The chain transfer agent here used can be, if necessary, a known chain transfer agent. In particular, a thiol compound is preferred, and can be widely selected from known thiol compounds. Specific examples can include t-dodecylmercaptan, mercaptoethanol, mercaptoacetic acid, and mercaptopropionic acid. A thiol compound having a structure in which a 2-hydroxy-1,1,1,3,3,3-hexafluoro-2-propyl group is bound to a saturated aliphatic hydrocarbon is particularly preferred because of having an effect of suppressing roughness and defects in a lithographic pattern. The amount of the chain transfer agent used can be selected depending on the intended molecular weight, the types of the monomer, the polymerization initiator, the chain transfer agent, the solvent, and the like, the structural unit composition, the polymerization temperature, the dropping rate, and the like.

The solvent for use in the polymerization reaction is not particularly limited as long as it can stably dissolve the raw material monomer, the polymerization initiator, the chain transfer agent, and a polymerization reaction product. Specific examples of the polymerization solvent can include ketones such as acetone, methyl ethyl ketone, methyl isobutyl ketone, methyl isoamyl ketone, methyl amyl ketone and cyclohexanone; alcohols such as methanol, ethanol and isopropanol; ether alcohols such as ethylene glycol monomethyl ether, ethylene glycol monoethyl ether, propylene glycol monomethyl ether and propylene glycol monoethyl ether; esters such as methyl acetate, ethyl acetate, isopropyl acetate, propyl acetate, butyl acetate, methyl propionate, methyl lactate and ethyl lactate; ether esters such as ethylene glycol monomethyl ether acetate, ethylene glycol monoethyl ether acetate, propylene glycol monomethyl ether acetate and propylene glycol monoethyl ether acetate; ethers such as tetrahydrofuran, 1,4-dioxane and ethylene glycol dimethyl ether; aromatic hydrocarbons such as toluene and xylene; N,N-dimethylformamide, and acetonitrile.

These can be used singly or used as a mixture of two or more kinds thereof. A compound high in solubilities of the monomer, the polymerization initiator, the chain transfer agent, and a polymerization reaction product and high in boiling point may be mixed and then used, for example, ethylene glycol monobutyl ether, 3-methoxy-3-methyl-1-butanol, 3-methoxy-3-methyl-1-butyl acetate, ethyl 3-ethoxypropionate, γ-butyrolactone, diethylene glycol dimethyl ether, N-methylpyrrolidone, or dimethylsulfoxide.

While the amount of the polymerization solvent used is not particularly limited, a so small amount of the solvent used may cause precipitation of the monomer and a too high viscosity and thus may allow no polymerization system to be homogeneously kept, and a so large amount used may cause an insufficient conversion rate of the monomer and/or cannot allow the molecular weight of a copolymer to be increased to a desired value. The amount is usually 0.5 to 20 parts by weight, preferably 1 to 10 parts by weight, based on 1 part by weight of the monomer.

The amount of a solvent charged in a reaction tank in advance (hereinafter, sometimes referred to as "solvent charged at the initial stage") in the dropping polymerization method may be equal to or more than the minimum amount enabling stirring to be made, and an excessively large amount is not preferred because the amount of a monomer solution which can be fed is decreased and production efficiency is reduced. The amount is usually selected from, for example, the range of 1/30 or more, preferably 1/20 to 1/2, particularly preferably 1/10 to 1/3 on a volume ratio, of the final amount of loading (namely, the total amount of the solvent charged at the initial stage, and the monomer solution and the initiator solution to be dropped). Herein, one portion of the monomer may also be mixed in the solvent charged at the initial stage in advance.

A short dropping time in the dropping polymerization method is not preferred because the degree of dispersion is easily broader and a large amount of the solution is dropped at one time to cause the occurrence of temperature drop of a polymerization liquid. On the contrary, a long dropping time is also not preferred because an excess heat history is applied to the copolymer and productivity deteriorates. Accordingly, the dropping time is usually selected from the range from 0.5 to 24 hours, preferably 1 to 12 hours, particularly preferably 2 to 8 hours.

After the termination of dropping and after a temperature rise to the polymerization temperature by a batch temperature rise method, the remaining unreacted monomer is preferably allowed to react by aging with maintaining of the temperature for a certain time, an additional temperature rise, or the like. Too long aging time is not preferred because the production efficiency per hour deteriorates and an excess heat history is applied to the copolymer. Accordingly, the aging time is usually selected from the range of 12 hours or less, preferably 6 hours or less, particularly preferably 1 to 4 hours.

The polymerization temperature can be appropriately selected depending on the boiling points of the solvent, the monomers, the chain transfer agent and the like, the half-life temperature of the polymerization initiator, and the like. A low temperature is problematic in terms of productivity because polymerization hardly progresses, and an excessively higher temperature is problematic in terms of stability of the monomer and the copolymer. Accordingly, the polymerization temperature is preferably selected from the range of 40 to 160°C, particularly preferably 60 to 120°C. The polymerization temperature needs to be precisely controlled because of having large effects on the molecular weight of the copolymer and the copolymerization composition. In this regard, common polymerization reaction is exothermal reaction and tends to increase the polymerization temperature, and thus is difficult to control to a fixed temperature. It is thus preferable in the present invention to contain at least one compound having a boiling point close to an objective polymerization temperature, in the polymerization solvent, and set the polymerization temperature at a temperature equal to or more than the initial boiling point at the polymerization pressure, of the compound. This method can suppress an increase in polymerization temperature by latent heat of vaporization of the polymerization solvent.

The polymerization pressure is not particularly limited, may be any of normal pressure, increased pressure or reduced pressure, and is usually normal pressure. In the case of radical polymerization, nitrogen gas is generated in the case of an azo-based initiator or oxygen gas is generated in the case of a peroxide-based initiator in radical generation from the initiator, and thus polymerization is preferably made at about atmospheric pressure with an open system as the polymerization system in order to suppress the variation in polymerization pressure.

### (Deprotection step)

In a case where polymerization is made with a monomer in which a phenolic hydroxyl group is protected with a protective group, as the monomer providing the structural unit II represented by the formula (ii), a deprotection step of removing the protective group to develop the phenolic hydroxyl group is needed. In the case of the polymer of the present invention, it is important for the deprotection step to not only remove only the protective group of the phenolic hydroxyl group, but also deprotect no acetal protective group of the structural unit I.

It is preferable therefor to adopt deprotection reaction using a base catalyst, and furthermore to use a base whose conjugate acid has a pKa of 12 or more. The pKa here mentioned is basically a value in water at 25°C. The base whose conjugate acid has a pKa of 12 or more is not particularly limited, and specific examples include hydroxides of alkali metals, such as lithium hydroxide, sodium hydroxide and potassium hydroxide, alkoxides of alkali metals, such as sodium methoxide and potassium methoxide, diazabicycloundecene, diazabicyclononene, 1,5,7-triazabicyclo[4.4.0]deca-5-ene, 7-methyl-1,5,7-triazabicyclo[4.4.0]deca-5-ene, and 1,1,3,3-tetramethylguanidine. In particular, sodium hydroxide, potassium hydroxide, sodium methoxide, potassium methoxide, and diazabicycloundecene are preferred.

The amount of the base catalyst used differs depending on the type of the base used and thus cannot be generally defined, and is usually 1 to 50% by mol, preferably 5 to 20% by mol based on the molar number of an acetyl group to be deprotected. When the amount of the base catalyst used is within the above range, a sufficient reaction rate is easily obtained.

The temperature of the deprotection reaction is within the range of 0 to 50°C, preferably 20 to 50°C. A reaction temperature higher than any temperature falling within the range causes undesirable side reaction, for example, desorption of an acetal group protecting carboxylic acid, and reaction of acetal desorbed, with a phenolic hydroxyl group of p-hydroxystyrene, and a reaction temperature lower than any temperature falling within the range is not preferred because a time is taken for the deprotection reaction and productivity deteriorates.

The solvent used in the deprotection reaction is not particularly limited as long as it can dissolve a copolymer before deprotection and a copolymer after deprotection. Specific examples of the solvent can include ketones such as acetone, methyl ethyl ketone, methyl isobutyl ketone, methyl isoamyl ketone, methyl amyl ketone and cyclohexanone, alcohols such as methanol, ethanol and isopropanol, ether alcohols such as ethylene glycol monomethyl ether, ethylene glycol monoethyl ether, propylene glycol monomethyl ether and propylene glycol monoethyl ether, esters such as methyl acetate, ethyl acetate, isopropyl acetate, propyl acetate, butyl acetate, methyl propionate, methyl lactate and ethyl lactate, ether esters such as ethylene glycol monomethyl ether acetate, ethylene glycol monoethyl ether acetate, propylene glycol monomethyl ether acetate and propylene glycol monoethyl ether acetate, ethers such as tetrahydrofuran, 1,4-dioxane and ethylene glycol dimethyl ether, aromatic hydrocarbons such as toluene and xylene, N,N-dimethylformamide, and acetonitrile. In particular, methanol, ethanol, isopropanol, propylene glycol monomethyl ether, methyl acetate, ethyl acetate, isopropyl acetate, propyl acetate, methyl propionate, ethylene glycol monomethyl ether acetate, ethylene glycol monoethyl ether acetate, and propylene glycol monomethyl ether acetate are preferred. These can be used singly or used as a mixture of two or more kinds thereof.

After the deprotection reaction, acid may be added in order to neutralize the base catalyst used in the deprotection reaction. Herein, the type and the amount of the acid added are to be noted so that no acetal in the polymer is desorbed. Specifically, weak acid such as oxalic acid or acetic acid is used and the amount of addition is 1 to 8 mol, preferably 2 to 3 mol based on 1 mol of the base.

### (Purification step)

The polymer obtained in the polymerization reaction includes impurities, for example, the solvent, the unreacted monomer, an oligomer, a reaction by-product, and the like, and purification may be further performed in order to remove them or obtain a polymer having a desired degree of dispersion.

Specifically, purification may be performed by a method involving diluting a solution including the polymer, if necessary, by addition of a good solvent, and then precipitating the polymer by contact with a poor solvent to extract impurities in a liquid phase (hereinafter, referred to as "precipitation purification"), or forming liquid-liquid two phases and then extracting the polymer in a good solvent phase and impurities in a poor solvent phase.

In the precipitation purification, a solid precipitated may be subjected to solid-liquid separation by a method such as filtration or decantation, and then further washed with a poor solvent or the like. Such purification may be performed before the deprotection step or after the deprotection step.

The types and the amounts of the poor solvent and the good solvent used for such purification are not particularly limited as long as the polymer can be separated from a low-molecular weight compound, and can be appropriately selected depending on the degree of dissolution of the polymer in the poor solvent, the type and the amount of the solvent used for polymerization, the types and the amounts of impurities, and the like.

The temperature in such purification needs to be critically controlled because of having large effects on the molecular weight and the degree of dispersion of the polymer, and the rates of removal of impurities such as the remaining monomer and the initiator residue. Too low purification temperature is not efficient because solubility of impurities in a precipitate extraction treatment solvent and a washing solvent is insufficient and no sufficient removal of impurities is performed, and on the contrary, too high purification temperature is not preferred because elution of the polymer in a purification solvent leads to off-balance of the composition of the polymer in a low-molecular region and/or a reduction in yield. Therefore, such purification is preferably performed in the range of 0 to 80°C, preferably in the range of 0 to 60°C.

The purification step may be carried out after the polymerization step, may be carried out after the deprotection step, or may be carried out both of them.

### [Resin composition for resists]

A polymer obtained in the production method of the present invention is useful as a base polymer of a resin composition for resists. The resin composition for resists includes, in addition to the polymer, an acid generator, an acid diffusion inhibitor, a solvent for homogeneously dissolving these, and the like, and these here used can be those conventionally known. The composition for resists can, if necessary, appropriately contain any compound(s) commonly used as additive(s) for resists, such as an organic carboxylic acid compound and/or an oxo acid compound of phosphorus, for the purposes of preventing the sensitivity of an acid generator from being degraded and enhancing a resist pattern shape, post-exposure delay and/or the like, an additional resin for improving performance of a resist film, and/or a surfactant, a dissolution inhibitor, a plasticizer, a stabilizer, a colorant, a halation inhibitor, and/or a dye, for enhancing coating ability.

### EXAMPLES

Hereinafter, modes of the present invention are described in detail with reference to Examples, but the present invention is not limited to these Examples at all. Herein, "part(s)" in the following Examples is/are on mass basis, unless particularly noted.

Each polymer in the present Examples was analyzed as follows.

### [Weight average molecular weight-molecular weight distribution]

The weight average molecular weight (Mw) and the molecular weight distribution (Mw/Mn) of each polymer synthesized as described below were measured by GPC (gel permeation chromatography), with polystyrene as a standard product.
Measurement apparatus: HPLC-8320GPC manufactured by Tosoh Corporation
Detector: differential refractive index (RI) detector
Column: Shodex GPC KF804 × 3 columns (manufactured by SHOWA DENKO K.K.)
Eluent: tetrahydrofuran
Flow rate: 1.0 mL/min
Temperature: 40°C
Calibration curve: created with polystyrene standard sample (Manufactured by Tosoh Corporation)

### [Polymer composition ratio and by-product composition ratio]

The composition ratio of a polymer as synthesized below and the by-product composition ratio were analyzed by ¹³C-NMR.
Apparatus: AVANCE500 manufactured by Bruker
Nuclear species: ¹³C
Measurement method: inverse gated decoupling
Cumulated number: 1000
Diameter of measurement tube: 5 mmϕ
Solvent: deuterated acetone
Relaxation reagent: Cr(III) acetylacetonate

### [Synthesis of polymer]

Monomers used for synthesis of polymers in Examples and Comparative Examples are shown below.

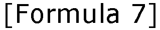

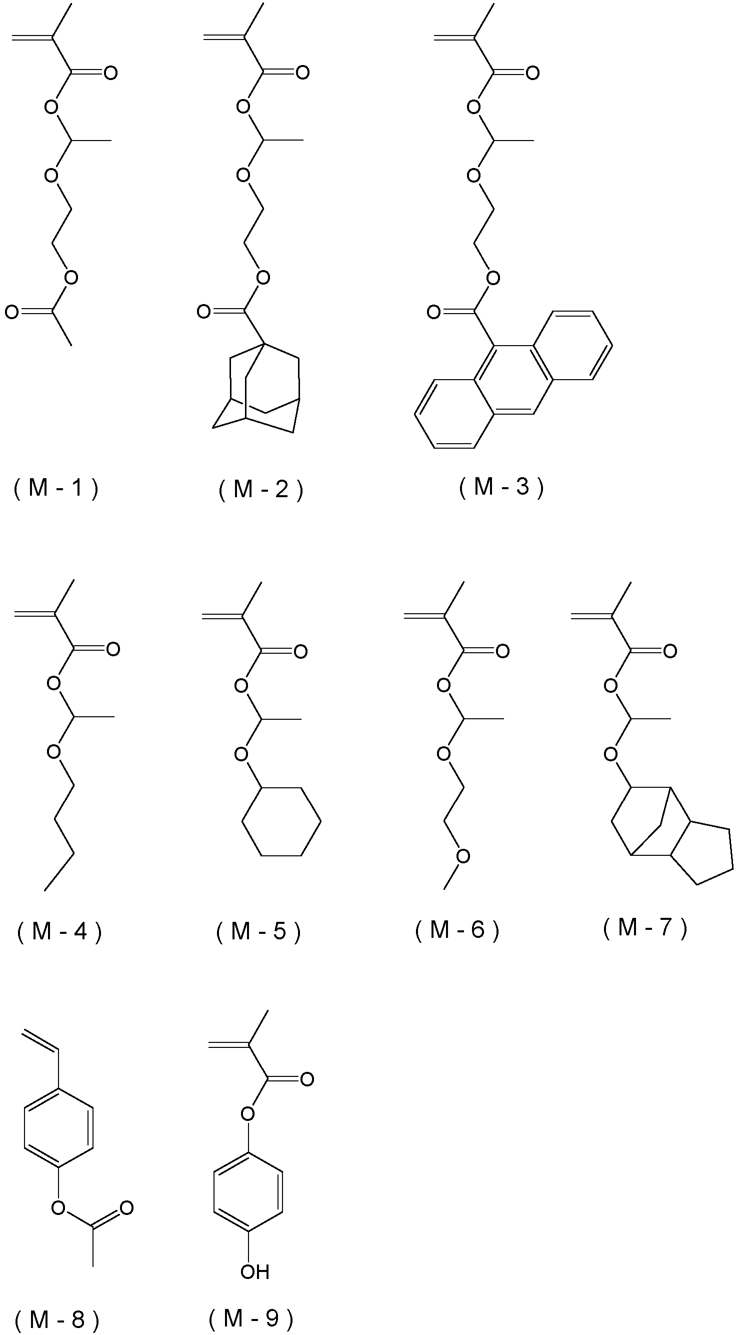

### [Example 1]

A reaction container equipped with a thermometer, a cooling tube and a stirring apparatus was loaded with 43 parts of ethyl acetate, and subjected to heating and reflux. Another container was loaded with 41 parts of monomer (M-8), 54 parts of monomer (M-1), 5 parts of dimethyl-2,2'-azobisisobutyrate and 73 parts of ethyl acetate, to prepare a monomer solution. The monomer solution was dropped to a reaction container under reflux of ethyl acetate over 2 hours, and thereafter reaction was continued for 2 hours. Thereafter, a solution in which 1 part of dimethyl-2,2'-azobisisobutyrate was dissolved in 5 parts of ethyl acetate was additionally charged, and furthermore reaction was continued for 2 hours, and then cooled.

To the polymerization liquid were added 88 parts of 10% by mass diazabicycloundecene (hereinafter, designated as DBU)/methanol solution and 115 parts of propylene glycol monomethyl ether acetate (hereinafter, designated as PGMEA), and stirred at 40°C for 4 hours, to perform deprotection of the structural unit derived from monomer (M-8) in the polymer and conversion to a p-hydroxystyrene (hereinafter, designated as PHS) structural unit.

Thereafter, the reaction liquid was dropped to 1057 parts of hexane, the resultant was stirred for 30 minutes and then left to still stand for 30 minutes, and a polymer precipitated was separated by decantation. After addition of 169 parts of methyl ethyl ketone to the polymer and dissolution, 1057 parts of hexane was added, the resultant was stirred for 30 minutes and then left to still stand for 30 minutes, and a polymer precipitated was separated by decantation.

To the polymer was added 423 parts of methyl ethyl ketone and dissolved, and 55 parts of an aqueous 3% oxalic acid solution and 110 parts of pure water were added thereto to perform washing with acid, and then removing a water layer. Subsequently, an operation of washing with 165 parts of pure water and removal of the water layer was repeated four times.

After 423 parts of PGMEA was added to an organic layer recovered and these were mixed, a low-boiling point solvent such as methyl ethyl ketone and excess PGMEA were distilled off at 40°C under reduced pressure, to finally prepare a PGMEA solution having a polymer concentration of 30% by mass.

The polymer obtained had a weight average molecular weight of 10,730 and a molecular weight distribution Mw/Mn of 1.68, and had the following structural units. The composition ratio of each of the structural units of the polymer was expressed by "% by mol". A methacrylic acid structural unit and a PHS-acetal-added structural unit indicating desorption and transfer of an acetal moiety were not detected.

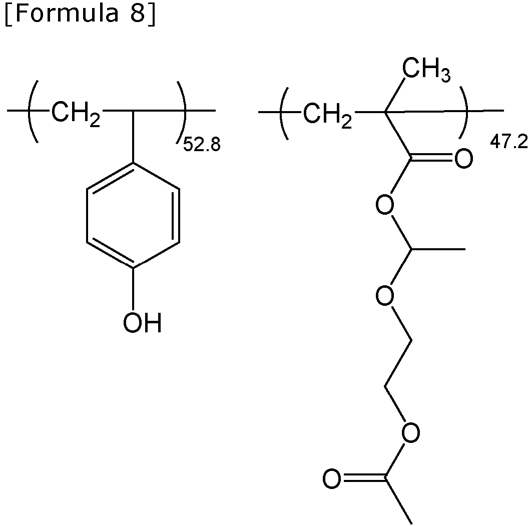

### [Example 2]

A reaction container equipped with a thermometer, a cooling tube and a stirring apparatus was loaded with 23 parts of ethyl acetate, and subjected to heating and reflux. Another container was loaded with 16 parts of monomer (M-8), 34 parts of monomer (M-2), 2 parts of dimethyl-2,2'-azobisisobutyrate and 38 parts of ethyl acetate, to prepare a monomer solution. The monomer solution was dropped to a reaction container under reflux of ethyl acetate over 2 hours, and thereafter reaction was continued for 2 hours. Thereafter, a solution in which 1 part of dimethyl-2,2'-azobisisobutyrate was dissolved in 2 parts of ethyl acetate was additionally charged, and furthermore reaction was continued for 2 hours, and then cooled.

To the polymerization liquid was added a solution in which 1 part of DBU was dissolved in 28 parts of methanol, and 51 parts of PGMEA, and stirred at 40°C for 4 hours, to perform deprotection of the structural unit derived from monomer (M-8) in the polymer and conversion to a PHS structural unit.

Thereafter, the reaction liquid was dropped to 451 parts of hexane, the resultant was stirred for 30 minutes and then left to still stand for 30 minutes, and a polymer precipitated was separated by decantation. After addition of 72 parts of ethyl acetate to the polymer and dissolution, 451 parts of hexane was added, the resultant was stirred for 30 minutes and then left to still stand for 30 minutes, and a polymer precipitated was separated by decantation.

To the polymer was added 181 parts of ethyl acetate and dissolved, 24 parts of an aqueous 3% oxalic acid solution and 47 parts of pure water were added thereto to perform washing with acid, and then removing a water layer. Subsequently, an operation of washing with 70 parts of pure water and removal of the water layer was repeated four times. After 181 parts of PGMEA was added to an organic layer recovered and these were mixed, a low-boiling point solvent such as ethyl acetate and excess PGMEA were distilled off at 40°C under reduced pressure, to finally prepare a PGMEA solution having a polymer concentration of 30% by mass.

The polymer obtained had a weight average molecular weight Mw of 13,230 and a molecular weight distribution Mw/Mn of 1.72, and had the following structural units. The composition ratio of each of the structural units of the polymer was expressed by "% by mol". A methacrylic acid structural unit and a PHS-acetal-added structural unit indicating desorption and transfer of an acetal moiety were not detected.

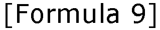

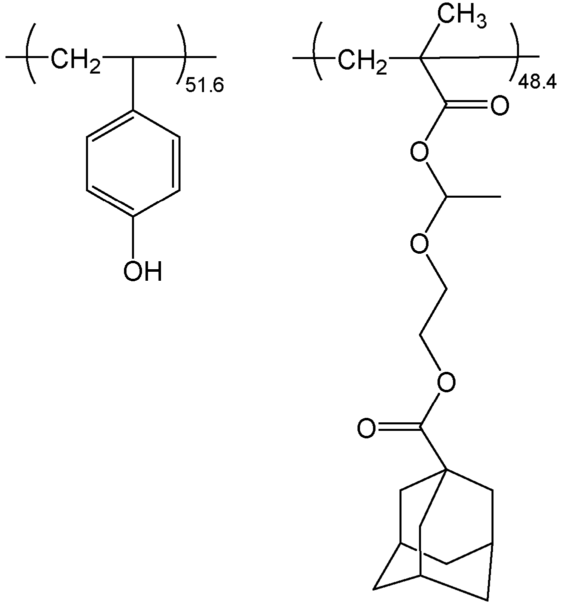

### [Example 3]

A reaction container equipped with a thermometer, a cooling tube and a stirring apparatus was loaded with 24 parts of ethyl acetate, and subjected to heating and reflux. Another container was loaded with 16 parts of monomer (M-8), 38 parts of monomer (M-3), 2 parts of dimethyl-2,2'-azobisisobutyrate and 42 parts of ethyl acetate, to prepare a monomer solution. The monomer solution was dropped to a reaction container under reflux of ethyl acetate over 2 hours, and thereafter reaction was continued for 2 hours. Thereafter, a solution in which 1 part of dimethyl-2,2'-azobisisobutyrate was dissolved in 2 parts of ethyl acetate was additionally charged, and furthermore reaction was continued for 2 hours, and then cooled.

To the polymerization liquid were added a solution in which 1 part of DBU was dissolved in 26 parts of methanol, and 51 parts of PGMEA, and stirred at 40°C for 4 hours, to perform deprotection of the structural unit derived from monomer (M-8) in the polymer and conversion to a PHS structural unit.

Thereafter, the reaction liquid was dropped to 446 parts of hexane, the resultant was stirred for 30 minutes and then left to still stand for 30 minutes, and a polymer precipitated was separated by decantation. After addition of 71 parts of ethyl acetate to the polymer and dissolution, 451 parts of hexane was added, the resultant was stirred for 30 minutes and then left to still stand for 30 minutes, and a polymer precipitated was separated by decantation.

To the polymer was added 71 parts of ethyl acetate and dissolved, and 23 parts of an aqueous 3% oxalic acid solution and 46 parts of pure water were added thereto to perform washing with acid, and then removing a water layer. Subsequently, an operation of washing with 70 parts of pure water and removal of the water layer was repeated four times.

After 71 parts of PGMEA was added to an organic layer recovered and these were mixed, a low-boiling point solvent such as ethyl acetate and excess PGMEA were distilled off at 40°C under reduced pressure, to finally prepare a PGMEA solution having a polymer concentration of 30% by mass.

The polymer obtained had a weight average molecular weight Mw of 7,184 and a molecular weight distribution Mw/Mn of 1.53, and had the following structural units. The composition ratio of each of the structural units of the polymer was expressed by "% by mol". A methacrylic acid structural unit and a PHS-acetal-added structural unit indicating desorption and transfer of an acetal moiety were not detected.

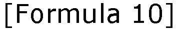

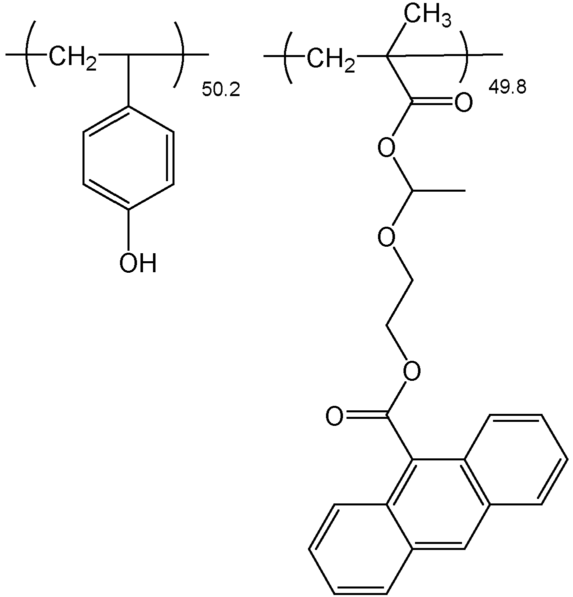

### [Example 4]

A reaction container equipped with a thermometer, a cooling tube and a stirring apparatus was loaded with 29 parts of methyl ethyl ketone, and subjected to heating and reflux. Another container was loaded with 22 parts of monomer (M-9), 42 parts of monomer (M-2), 3 parts of dimethyl-2,2'-azobisisobutyrate and 50 parts of methyl ethyl ketone, to prepare a monomer solution. The monomer solution was dropped to a reaction container under reflux of ethyl acetate over 2 hours, and thereafter reaction was continued for 2 hours. Thereafter, a solution in which 1 part of dimethyl-2,2'-azobisisobutyrate was dissolved in 3 parts of methyl ethyl ketone was additionally charged, and furthermore reaction was continued for 2 hours, and then cooled.

Thereafter, the polymerization liquid was dropped to 372 parts of hexane, the resultant was stirred for 30 minutes and then left to still stand for 30 minutes, and a polymer precipitated was separated by decantation. After addition of 60 parts of methyl ethyl ketone to the polymer and dissolution, 372 parts of hexane was added, the resultant was stirred for 30 minutes and then left to still stand for 30 minutes, and a polymer precipitated was separated by decantation.

After 149 parts of PGMEA was added to an organic layer recovered and these were mixed, a low-boiling point solvent such as methyl ethyl ketone and excess PGMEA were distilled off at 40°C under reduced pressure, to finally prepare a PGMEA solution having a polymer concentration of 30% by mass.

The polymer obtained had a weight average molecular weight Mw of 17,840 and a molecular weight distribution Mw/Mn of 2.43, and had the following structural units. The composition ratio of each of the structural units of the polymer was expressed by "% by mol". A methacrylic acid structural unit and a structural unit in which acetal was added to the structural unit derived from monomer (M-9), indicating desorption and transfer of an acetal moiety, were not detected.

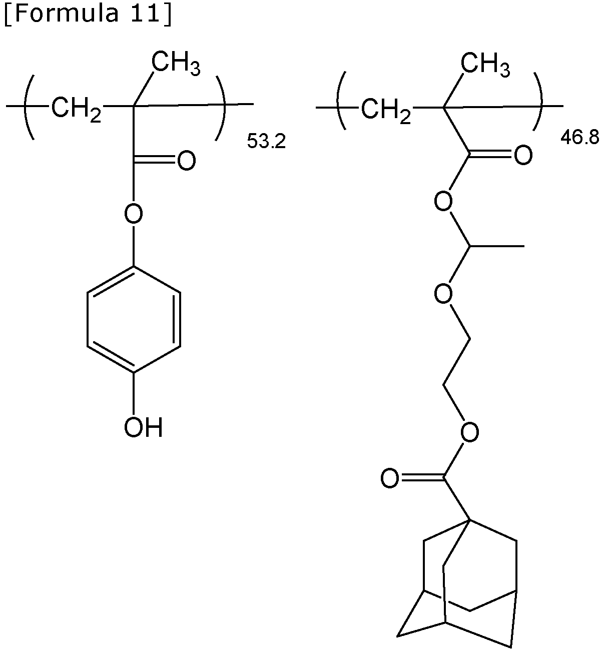

### [Comparative Example 1]

A reaction container equipped with a thermometer, a cooling tube and a stirring apparatus was loaded with 85 parts of ethyl acetate, and subjected to heating and reflux. Another container was loaded with 81 parts of monomer (M-8), 106 parts of monomer (M-5), 41 parts of dimethyl-2,2'-azobisisobutyrate and 143 parts of ethyl acetate, to prepare a monomer solution. The monomer solution was dropped to a reaction container under reflux of ethyl acetate over 2 hours, and thereafter reaction was continued for 2 hours. Thereafter, a solution in which 3 parts of dimethyl-2,2'-azobisisobutyrate was dissolved in 10 parts of ethyl acetate was additionally charged, and furthermore reaction was continued for 2 hours, and then cooled.

To the polymerization liquid were added a solution in which 8 parts of DBU was dissolved in 160 parts of methanol, and 228 parts of PGMEA, and stirred at 40°C for 4 hours, to perform deprotection of the structural unit derived from monomer (M-8) in the polymer and conversion to a PHS structural unit.

Thereafter, the reaction liquid was dropped to 2090 parts of hexane, the resultant was stirred for 30 minutes and then left to still stand for 30 minutes, and a polymer precipitated was separated by decantation. After addition of 334 parts of ethyl acetate to the polymer and dissolution, 2090 parts of hexane was added, the resultant was stirred for 30 minutes and then left to still stand for 30 minutes, and a polymer precipitated was separated by decantation.

To the polymer was added 836 parts of ethyl acetate and dissolved, and 109 parts of an aqueous 3% oxalic acid solution and 217 parts of pure water were added thereto to perform washing with acid, and then removing a water layer. Subsequently, an operation of washing with 326 parts of pure water and removal of the water layer was repeated four times. After 423 parts of PGMEA was added to an organic layer recovered and these were mixed, a low-boiling point solvent such as ethyl acetate and excess PGMEA were distilled off at 40°C under reduced pressure, to finally prepare a PGMEA solution having a polymer concentration of 30% by mass.

The polymer obtained had a weight average molecular weight Mw of 10,630 and a molecular weight distribution Mw/Mn of 1.64, and had the following structural units. The composition ratio of each of the structural units of the polymer was expressed by "% by mol". A methacrylic acid structural unit and a PHS-acetal-added structural unit indicating desorption and transfer of an acetal moiety were not detected.

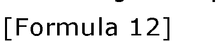

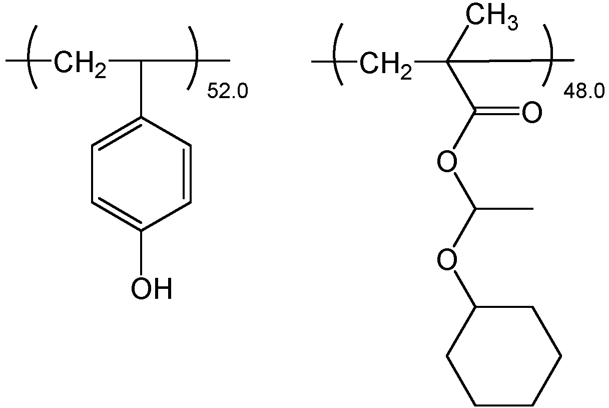

### [Comparative Example 2]

A reaction container equipped with a thermometer, a cooling tube and a stirring apparatus was loaded with 80 parts of ethyl acetate, and subjected to heating and reflux. Another container was loaded with 81 parts of monomer (M-8), 94 parts of monomer (M-6), 10 parts of dimethyl-2,2'-azobisisobutyrate and 134 parts of ethyl acetate, to prepare a monomer solution. The monomer solution was dropped to a reaction container under reflux of ethyl acetate over 2 hours, and thereafter reaction was continued for 2 hours. Thereafter, a solution in which 3 parts of dimethyl-2,2'-azobisisobutyrate was dissolved in 10 parts of ethyl acetate was additionally charged, and furthermore reaction was continued for 2 hours, and then cooled.

To the polymerization liquid were added a solution in which 15 parts of DBU was dissolved in 159 parts of methanol, and 213 parts of PGMEA, and stirred at 40°C for 4 hours, to perform deprotection of the structural unit derived from monomer (M-8) in the polymer and conversion to a PHS structural unit.

Thereafter, the reaction liquid was dropped to 1993 parts of hexane, the resultant was stirred for 30 minutes and then left to still stand for 30 minutes, and a polymer precipitated was separated by decantation.

To the polymer were added 319 parts of ethyl acetate, 156 parts of an aqueous 3% oxalic acid solution, 155 parts of pure water and 143 parts of isopropanol, and washing with acid was performed, and then removing a layer. Subsequently, an operation of adding 311 parts of pure water and 143 parts of isopropanol to perform washing with water and removal of the water layer was repeated three times.

After 319 parts of PGMEA was added to an organic layer recovered and these were mixed, a low-boiling point solvent and excess PGMEA were distilled off at 40°C under reduced pressure, to finally prepare a PGMEA solution having a polymer concentration of 30% by mass.

The polymer obtained had a weight average molecular weight Mw of 11,420 and a molecular weight distribution Mw/Mn of 1.74, and had the following structural units. The composition ratio of each of the structural units of the polymer was expressed by "% by mol". A methacrylic acid structural unit and a PHS-acetal-added structural unit indicating desorption and transfer of an acetal moiety were not detected.

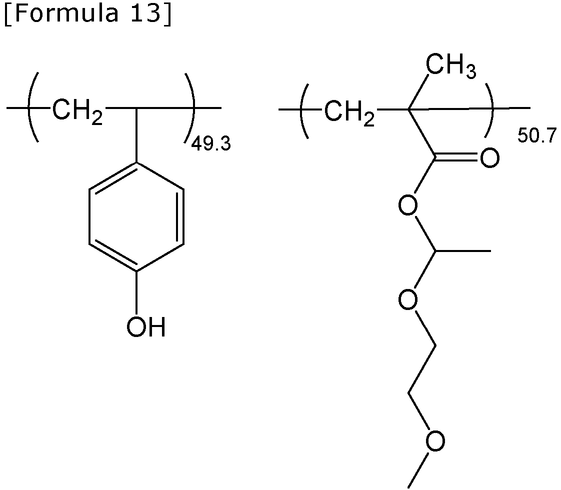

### [Comparative Example 3]

A reaction container equipped with a thermometer, a cooling tube and a stirring apparatus was loaded with 19 parts of ethyl acetate, and subjected to heating and reflux. Another container was loaded with 16 parts of monomer (M-8), 26 parts of monomer (M-7), 2 parts of dimethyl-2,2'-azobisisobutyrate and 37 parts of ethyl acetate, to prepare a monomer solution. The monomer solution was dropped to a reaction container under reflux of ethyl acetate over 2 hours, and thereafter reaction was continued for 2 hours. Thereafter, a solution in which 1 part of dimethyl-2,2'-azobisisobutyrate was dissolved in 2 parts of ethyl acetate was additionally charged, and furthermore reaction was continued for 2 hours, and then cooled.

To the polymerization liquid were added a solution in which 2 parts of DBU was dissolved in 32 parts of methanol, and 52 parts of PGMEA, and stirred at 40°C for 4 hours, to perform deprotection of the structural unit derived from monomer (M-8) in the polymer and conversion to a PHS structural unit.

Thereafter, the reaction liquid was dropped to 464 parts of hexane, the resultant was stirred for 30 minutes and then left to still stand for 30 minutes, and a polymer precipitated was separated by decantation. After addition of 74 parts of ethyl acetate to the polymer and dissolution, 464 parts of hexane was added, the resultant was stirred for 30 minutes and then left to still stand for 30 minutes, and a polymer precipitated was separated by decantation.

To the polymer was added 185 parts of ethyl acetate and dissolved, and 24 parts of an aqueous 3% oxalic acid solution and 48 parts of pure water were added thereto to perform washing with acid, and then removing a water layer. Subsequently, an operation of washing with 72 parts of pure water and removal of the water layer was repeated four times. After 185 parts of PGMEA was added to an organic layer recovered and these were mixed, a low-boiling point solvent such as ethyl acetate and excess PGMEA were distilled off at 40°C under reduced pressure, to finally prepare a PGMEA solution having a polymer concentration of 30% by mass.

The polymer obtained had a weight average molecular weight Mw of 11,880 and a molecular weight distribution Mw/Mn of 1.62, and had the following structural units. The composition ratio of each of the structural units of the polymer was expressed by "% by mol". A methacrylic acid structural unit and a PHS-acetal-added structural unit indicating desorption and transfer of an acetal moiety were not detected.

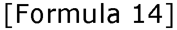

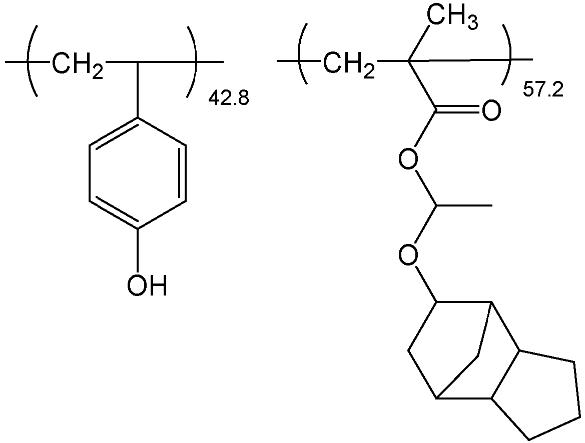

### [Comparative Example 4]

A reaction container equipped with a thermometer, a cooling tube and a stirring apparatus was loaded with 71 parts of methyl ethyl ketone, and subjected to heating and reflux. Another container was loaded with 72 parts of monomer (M-8), 83 parts of monomer (M-4), 10 parts of dimethyl-2,2'-azobisisobutyrate and 119 parts of methyl ethyl ketone, to prepare a monomer solution. The monomer solution was dropped to a reaction container over 2 hours, and thereafter reaction was continued for 2 hours. Thereafter, a solution in which 3 parts of dimethyl-2,2'-azobisisobutyrate was dissolved in 10 parts of methyl ethyl ketone was additionally charged, and furthermore reaction was continued for 2 hours, and then cooled.

The polymerization liquid was dropped to 750 parts of hexane, the resultant was stirred for 30 minutes and then left to still stand for 30 minutes, and a polymer precipitated was separated by decantation. After addition of 120 parts of acetone to the polymer and dissolution, 750 parts of hexane was again dropped, the resultant was stirred for 30 minutes and then left to still stand for 30 minutes, and a polymer precipitated was separated by decantation.

The polymer was dissolved in 300 parts of PGMEA, a low-boiling point solvent such as acetone and excess PGMEA were distilled off at 40°C under reduced pressure, to finally prepare a PGMEA solution having a polymer concentration of 45% by weight.

To 11 parts of the polymer solution was added 2 parts of a 10% by mass DBU/methanol solution, and these were stirred at 40°C for 4 hours, to perform deprotection of the structural unit derived from monomer (M-8) in the polymer and conversion to a PHS structural unit. After deprotection reaction, 2.2 parts of a 20% by mass acetic acid/PGMEA solution was added for neutralization.

The polymer obtained had a weight average molecular weight Mw of 9,110 and a molecular weight distribution Mw/Mn of 1.45, and had the following structural units. The composition ratio of each of the structural units of the polymer was expressed by "% by mol". A methacrylic acid structural unit and a PHS-acetal-added structural unit indicating desorption and transfer of an acetal moiety were not detected.

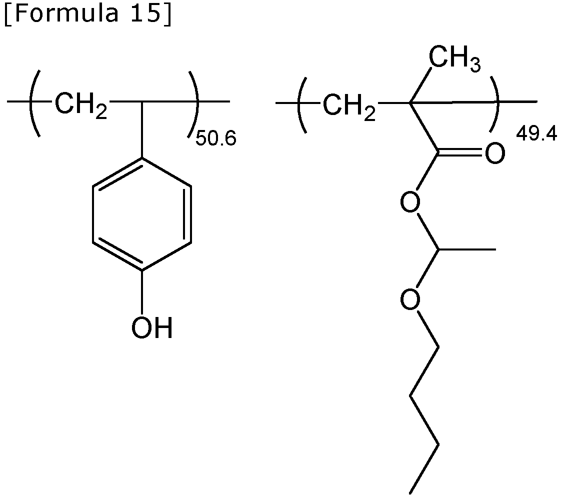

### [Storage stability test]

The polymer solutions of Examples 1 to 4 and Comparative Examples 1 to 4 were each stored at 40°C, and subjected to ¹³C-NMR analysis after 2 weeks and 4 weeks, to examine the change in polymer structure.

The total molar ratio of a methacrylic acid structural unit and a structural unit in which acetal was added to a phenolic hydroxyl group, which were generated due to desorption and transfer of an acetal protective group of the structural units derived from monomers (M-1) to (M-7), was calculated as the by-product composition (% by mol).

**[Table 1]**

| | Polymer composition (% by mol) | By-product composition (% by mol) | | |
|---|---|---|---|---|
| | | Immediately after production | 2 weeks | 4 weeks |
| Example 1 | PHS/M-1 = 52.8/47.2 | 0.0 | 1.7 | 2.5 |
| Example 2 | PHS/M-2 = 51.6/48.4 | 0.0 | 0.0 | 0.0 |
| Example 3 | PHS/M-3 = 50.2/49.8 | 0.0 | 0.0 | 0.0 |
| Example 4 | M-9/M-2 = 53.2/46.8 | 0.0 | 0.0 | 2.5 |
| Comparative Example 1 | PHS/M-5 = 52.0/48.0 | 0.0 | 29.7 | 39.3 |
| Comparative Example 2 | PHS/M-6 = 49.3/50.7 | 0.0 | 2.4 | 4.8 |
| Comparative Example 3 | PHS/M-7 = 42.8/57.2 | 0.0 | 11.7 | 21.5 |
| Comparative Example 4 | PHS/M-4 = 50.6/49.4 | 0.0 | 5.9 | 23.6 |

The polymer of the present invention is suppressed in desorption of an acetal moiety in the polymer even in an acceleration test at 40°C, and enhanced in storage stability.

### Industrial Applicability

The polymer of the present invention can be utilized for a resin composition for resists, which is excellent in storage stability and high in sensitivity.

## Claims

1. A polymer containing
a structural unit I represented by the following general formula (i): 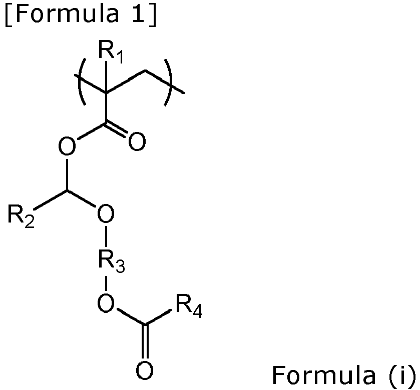 in the formula (i), R₁ represents a hydrogen atom or an alkyl group having 1 to 10 carbon atoms, R₂ represents an alkyl group having 1 to 10 carbon atoms, R₃ represents an alkylene group having 1 to 5 carbon atoms, and R₄ represents a hydrocarbon group having 1 to 20 carbon atoms, and
a structural unit II represented by the following general formula (ii): 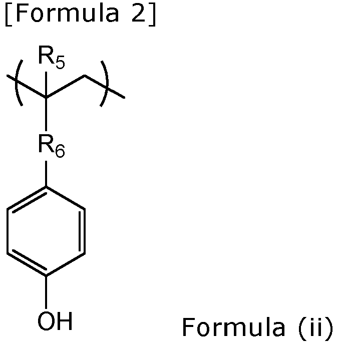 in the formula (ii), R₅ represents a hydrogen atom or an alkyl group having 1 to 10 carbon atoms, and R₆ represents a single bond or -C(=O)-O-.

2. The polymer according to claim 1, wherein R₄ in the formula (i) is a hydrocarbon group containing an alicyclic group or an aryl group and having 5 to 20 carbon atoms.

3. A polymer containing
a structural unit I-1 represented by the following general formula (i-1): 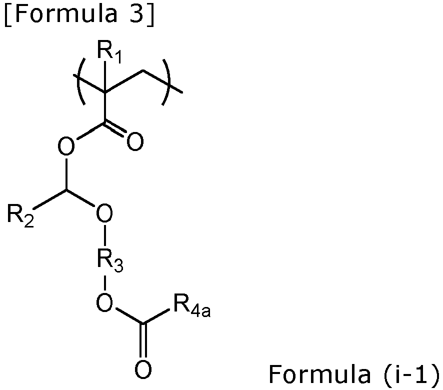 in the formula (i-1), R₁ represents a hydrogen atom or an alkyl group having 1 to 10 carbon atoms, R₂ represents an alkyl group having 1 to 10 carbon atoms, R₃ represents an alkylene group having 1 to 5 carbon atoms, and R₄ₐ represents a hydrocarbon group containing an alicyclic group or an aryl group and having 5 to 20 carbon atoms.

4. A resin composition for resists, the resin composition comprising the polymer according to any one of claims 1 to 3.
